# FASCICULE DE BREVET EUROPEEN

(11) **EP 4 500 575 B1**
(45) Date de publication et mention de la délivrance du brevet: **01.07.2026**
(21) Numéro de dépôt: 23709735.7
(22) Date de dépôt: 10.03.2023
(51) Int. Cl.: H10P 90/00, H10P 10/00, C23C 16/00, C30B 28/14, C30B 29/36, C30B 33/06, C23C 16/32

(54) **STRUCTURE COMPOSITE COMPRENANT UNE COUCHE MINCE MONOCRISTALLINE SUR UN SUBSTRAT SUPPORT EN CARBURE DE SILICIUM POLY-CRISTALLIN ET PROCÉDÉ DE FABRICATION ASSOCIÉ**
VERBUNDSTRUKTUR MIT EINER MONOKRISTALLINEN DÜNNSCHICHT AUF EINEM POLYKRISTALLINEN SILICIUMCARBIDTRÄGERSUBSTRAT UND ZUGEHÖRIGES HERSTELLUNGSVERFAHREN
COMPOSITE STRUCTURE COMPRISING A MONOCRYSTALLINE THIN FILM ON A POLYCRYSTALLINE SILICON CARBIDE SUPPORT SUBSTRATE, AND ASSOCIATED MANUFACTURING METHOD

(30) Priorité: 30.03.2022 FR 2202859
(43) Date de publication de la demande: 05.02.2025
(73) Titulaire: SOITEC, 38190 Bernin (FR)
(72) Inventeur: BIARD, Hugo, 38190 BERNIN (FR); POTIER, Alexandre, 78480 VERNEUIL SUR SEINE (FR); FERRATO, Marc, 65310 HORGUES (FR); LEFEVRE, Pablo, 92700 COLOMBES (FR)
(74) Mandataire: IP Trust
(86) Numéro de dépôt international: PCT/EP2023/056240
(87) Numéro de publication internationale: WO 2023/186498

(56) Documents cités:
- US-B2- 10 934 634
- GUY CHICHIGNOUD ET AL: "Processing of Poly-SiC Substrates with Large Grains for Wafer-Bonding", MATERIALS SCIENCE FORUM, vol. 527-529, 15 October 2006 (2006-10-15), pages 71 - 74, XP055342308, DOI: 10.4028/www.scientific.net/MSF.527-529.71

## Description

### DOMAINE DE L'INVENTION

La présente invention concerne le domaine des matériaux semi-conducteurs pour composants microélectroniques. Elle concerne en particulier une structure composite comprenant une couche mince monocristalline disposée sur un substrat support en carbure de silicium poly-cristallin. La couche mince monocristalline est préférentiellement en carbure de silicium, et la structure composite vise les applications d'électronique de puissance.

### ARRIERE PLAN TECHNOLOGIQUE DE L'INVENTION

Le SiC est de plus en plus largement utilisé pour la fabrication de dispositifs de puissance innovants, pour répondre aux besoins de domaines montants de l'électronique, comme notamment les véhicules électriques. En effet, les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures.

Les substrats en SiC monocristallin (c-SiC) de haute qualité, destinés à l'industrie microélectronique, restent néanmoins chers et difficiles à approvisionner en grande taille. Il est donc avantageux de recourir à des solutions de transfert de couches, pour élaborer des structures composites comprenant typiquement une couche mince en SiC monocristallin (issue du substrat en c-SiC de haute qualité) sur un substrat support plus bas coût, par exemple en SiC poly-cristallin (p-SiC). Les composants électroniques peuvent ensuite être élaborés sur et/ou dans la couche mince.

Une solution de transfert de couche mince bien connue est le procédé Smart Cut^{™}, basé sur une implantation d'ions légers et sur un assemblage, par collage direct, entre un substrat donneur monocristallin et un substrat support, au niveau d'une interface de collage.

Des substrats en p-SiC, susceptibles de former des substrats supports, sont actuellement disponibles sur le marché. Néanmoins, leurs caractéristiques mécaniques, électriques, voire thermiques ne sont pas nécessairement optimaux pour l'obtention, à partir d'un procédé de transfert de couche mince, d'une structure composite de haute qualité, visant des applications de puissance.

La publication « Processing of poly-SiC substrates with large grains for wafer-bonding, par Guy Chichignoud et al; doi:10.4028/www.scientific.net/MSF.527-529.71, XP055342308, décrit un transfert, par collage de plaquettes, de films minces de SiC monocristallin sur un support en SiC polycristallin pour obtenir une « quasi-plaquette » afin de réduire le coût des plaquettes de carbure de silicium.

Comme évoqué plus haut, les applications d'électronique de puissance requièrent une excellente conduction électrique verticale dans la structure composite. La couche mince monocristalline peut ainsi être dopée, selon les besoins de l'application : par exemple, pour présenter un dopage de type N et une résistivité inférieure ou égale à 30mohm.cm, à 10mohm.cm, voire inférieure à 1mohm.cm. Mais il est également requis d'assurer une bonne conductivité électrique dans le substrat support de la structure composite. Pour cela, il est habituel de doper fortement (en particulier, de type N) le substrat poly-cristallin, pour atteindre une résistivité inférieure à 30mohm.cm. En outre, l'interface d'assemblage de la structure composite doit être élaborée de manière à ne pas (ou très peu) augmenter la résistance électrique verticale.

Il existe néanmoins d'autres applications, qui ne nécessitent pas une conduction électrique verticale, mais au contraire qui visent une haute résistivité du substrat support : c'est en particulier le cas des applications radiofréquences. Les autres caractéristiques du substrat support énoncées ci-dessous (mécaniques, voire thermiques) sont requises pour ces applications RF, ainsi que pour les applications de puissance.

Un procédé de transfert de couche mince, basé sur un collage direct par adhésion moléculaire, est très dépendant de la qualité de surface des substrats assemblés. En particulier, une rugosité inférieure ou égale à 1nm RMS (rugosité moyenne quadratique) est requise, couplée à une défectivité de surface (particules, trous... ou autres reliefs susceptibles de générer des défauts de collage) très faible, tant pour le substrat support que pour le substrat donneur.

La dureté du SiC ainsi que la présence de grains à la surface du substrat support poly-cristallin complexifie grandement la préparation de surface et une qualité parfaite s'avère difficile à obtenir.

Enfin, il est essentiel d'utiliser des substrats supports présentant une courbure ou déformation faible. La courbure correspond à la flèche ou « warp » selon la terminologie anglo-saxonne, lequel équivaut à la différence algébrique des déviations du substrat par rapport à un plan de référence. Une courbure réduite est requise d'une part, pour que ces substrats supports soient compatibles avec un assemblage direct de bonne qualité et une forte énergie de collage, et d'autre part pour qu'ils ne soient pas susceptibles de provoquer des dommages dans la couche mince monocristalline durant ou après le procédé de transfert, du fait de contraintes mécaniques importantes. Une courbure faible est également importante pour garantir les performances des étapes de fabrication (par exemple, photolithographie) des composants sur/dans la couche mince de la structure composite. Le rayon de courbure (proportionnel à l'inverse du « warp ») des substrats supports en p-SiC est typiquement visé supérieur à environ 25m, soit une courbure (« warp ») inférieure ou égale à 100 micromètres (les micromètres seront notés « microns » dans la suite du texte, par simplification) pour un substrat de 150mm de diamètre par exemple.

De surcroit, il apparait souvent important que le substrat support garantisse une bonne conductibilité thermique, pour évacuer efficacement la chaleur, notamment générée par des composants de puissance.

L'ensemble de ces spécifications est très complexe à atteindre par les substrats en p-SiC.

Le document US10934634 propose un substrat en p-SiC pour lequel le taux de changement de la taille des grains entre les deux faces du substrat est inférieur à 0,43%, ce qui lui procure un rayon de courbure supérieur à 142m. En outre, une face au moins dudit substrat présente une rugosité moyenne arithmétique inférieure à 1nm.

Ce procédé demeure néanmoins dispendieux et très consommateur en énergie et en matière, car une importante portion du p-SiC initialement déposé sur un substrat de graphite est retirée et perdue pour obtenir le substrat proposé en p-SiC (typiquement 2mm initialement déposés pour former un substrat en p-SiC de 350 microns).

### OBJET DE L'INVENTION

La présente invention propose une structure composite comportant une couche mince en matériau monocristallin, en particulier en c-SiC, disposée sur un substrat support en p-SiC. Elle concerne également un procédé de fabrication d'une telle structure composite.

### BREVE DESCRIPTION DE L'INVENTION

L'invention concerne une structure composite pour la fabrication de composants microélectroniques comprenant une couche mince monocristalline, disposée sur un substrat support en carbure de silicium poly-cristallin, ledit substrat support présentant une orientation cristalline préférentielle selon laquelle :
- un coefficient de texture C₄₂₂ est inférieur à 30%, en particulier inférieur à 20%, et
- un coefficient de texture C₂₂₀ est supérieur à 60% ou la somme des coefficients de texture C₁₁₁+C₂₂₂+C₅₁₁ est supérieure à 70%, en particulier supérieure à 80%.

Selon d'autres caractéristiques avantageuses et non limitatives de l'invention, prises seules ou selon toute combinaison techniquement réalisable :
- le substrat support présente un dopage à l'azote et une résistivité inférieure à 30mOhm.cm ;
- la couche mince est composée de carbure de silicium ;
- la couche mince est composée de diamant ;
- la structure composite comprend une couche intermédiaire continue ou discontinue, disposée entre la couche mince et le substrat support, et composée d'au moins un matériau métallique ou semi-conducteur ;
- la couche intermédiaire est composée de silicium, de carbure de silicium, de tungstène, et/ou de titane ;
- le coefficient de texture C₄₂₂ est inférieur à 15%, voire inférieur à 10% ;
- le substrat support présente une épaisseur comprise entre 50 microns et 800 microns, préférentiellement entre 60 microns et 500 microns ;
- la structure composite comprend un composant électronique sur et/ou dans la couche mince, et optionnellement comprend un contact électrique au niveau de la face arrière du substrat support.

La présente invention concerne également un procédé de fabrication d'une structure composite comportant une couche mince monocristalline disposée sur un substrat support en carbure de silicium poly-cristallin, le procédé de fabrication comprenant les étapes suivantes :
a) la fourniture d'un substrat support en carbure de silicium poly-cristallin présentant une orientation cristalline préférentielle selon laquelle :
   - un coefficient de texture C₄₂₂ est inférieur à 30%, en particulier inférieur à 20%, et
   - un coefficient de texture C₂₂₀ est supérieur à 60% ou la somme des coefficients de texture C₁₁₁+C₂₂₂+C₅₁₁ **est** supérieure à 70%, en particulier supérieure à 80%,
b) la fourniture d'un substrat donneur en un matériau monocristallin,
c) le transfert d'une couche mince issue du substrat donneur sur le substrat support.

Selon d'autres caractéristiques avantageuses et non limitatives de l'invention, prises seules ou selon toute combinaison techniquement réalisable :
- l'étape c) de transfert comprend :
   c1) la formation d'un plan fragile enterré dans le substrat donneur, délimitant la couche mince entre ledit plan fragile enterré et une face avant du substrat donneur,
   c2) l'assemblage par collage par adhésion moléculaire du substrat donneur sur le substrat support, directement ou via une couche intermédiaire,
   c3) la séparation le long du plan fragile enterré pour donner lieu au transfert de la couche mince sur le substrat support ;
- l'étape c2) comprend, avant l'assemblage des deux substrats :
   - la formation d'une couche intermédiaire sur le substrat donneur, avant ou après l'étape c1), et/ou
   - la formation d'une couche intermédiaire sur le substrat support,
      la couche intermédiaire (30) étant formée en au moins un matériau métallique ou semi-conducteur, choisi parmi le silicium, le carbure de silicium, le tungstène et le titane ;
- le matériau monocristallin composant le substrat donneur est le carbure de silicium ;
- le procédé de fabrication comprend en outre l'élaboration de composants électroniques sur et/ou dans la couche mince de la structure composite ;
- l'élaboration de composants électroniques comprend notamment une étape d'homoépitaxie ou d'hétéroépitaxie sur la couche mince.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1] La figure 1 présente un substrat composite conforme à l'invention ;
[Fig. 2] La figure 2 présente une table répertoriant les 10 pics de diffraction, classés par indices de Miller (hkl) croissants, pris en compte dans un substrat SiC de polytype 3C et mesurables par diffraction aux rayons X ; sont également indiquées dans la table, la position des pics et leur intensité théorique ;
[Fig. 3a]
[Fig. 3b]

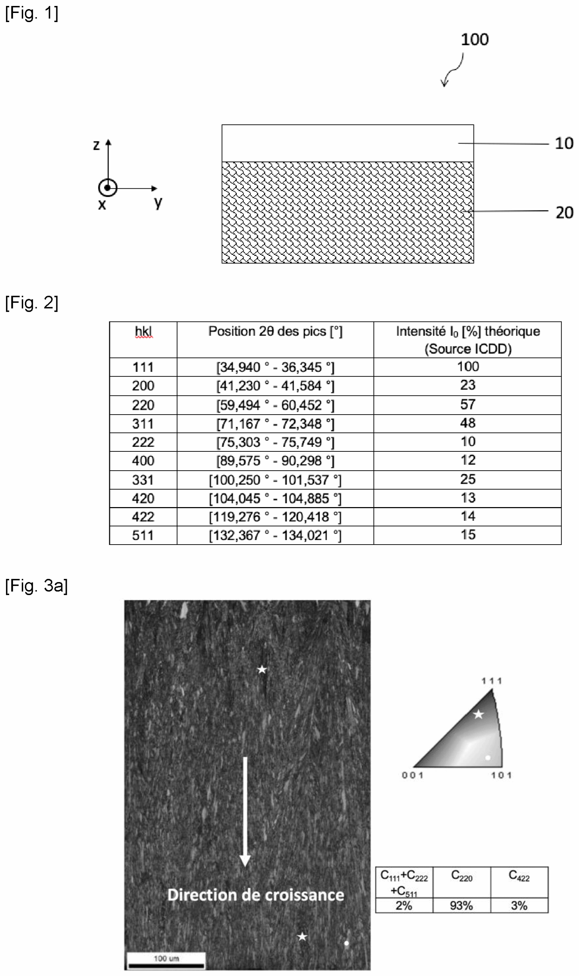

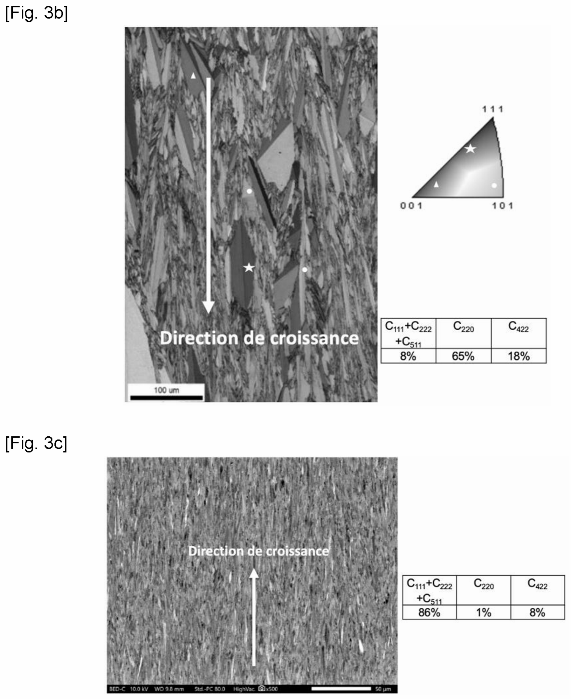

[Fig. 3c] Les figures 3a, 3b, 3c présentent des micrographies (MEB) de substrats supports, élaborés dans différentes conditions et présentant différentes orientations cristallines préférentielles ou textures, mis en œuvre pour fabriquer des structures composites conformes à la présente invention ;

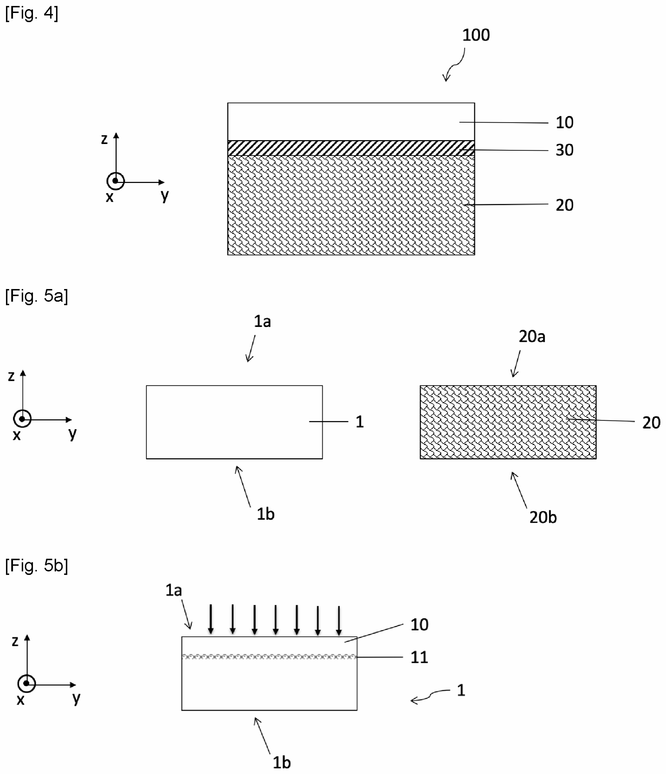

[Fig. 4] La figure 4 présente un substrat composite conforme à l'invention ;
[Fig. 5a]
[Fig. 5b]
[Fig. 5c]
[Fig. 5c']
[Fig. 5c"]

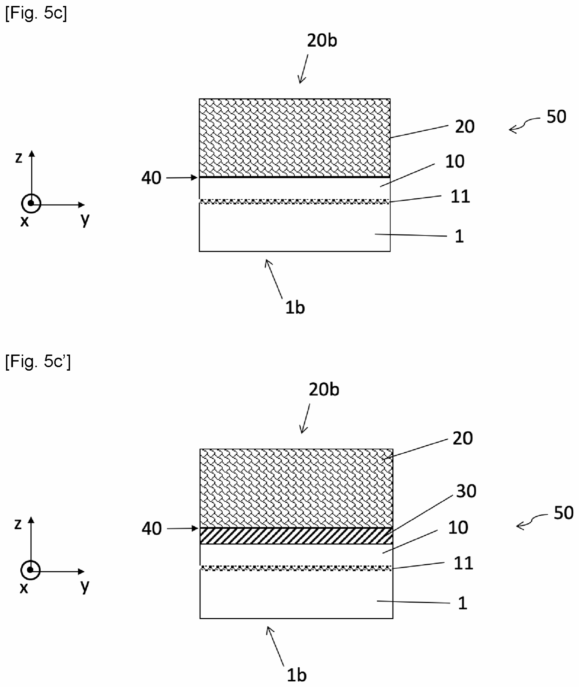

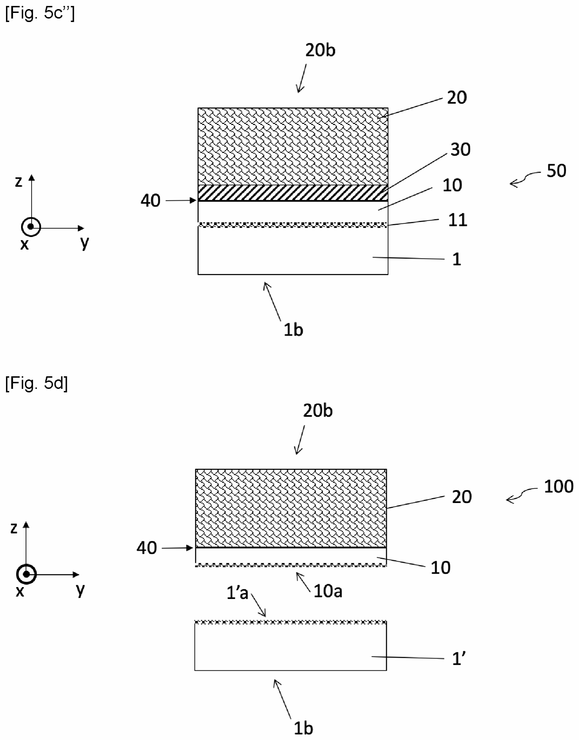

[Fig. 5d] Les figures 5a, 5b, 5c, 5c', 5c" et 5d présentent des étapes du procédé de fabrication conforme à l'invention ;

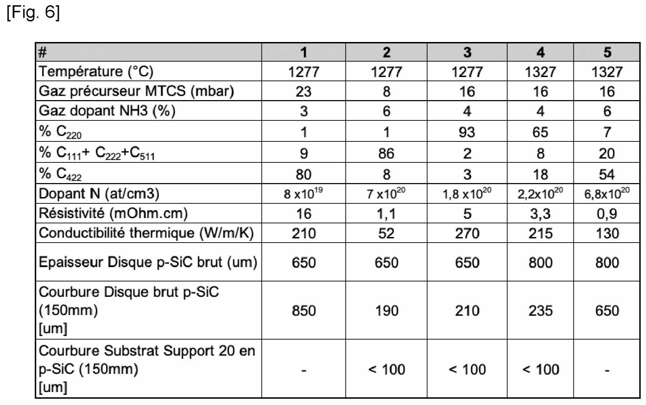

[Fig. 6] La figure 6 présente des conditions d'élaboration et les caractéristiques associées de cinq types de substrats supports, les substrats supports 2, 3 et 4 étant adaptés pour des structures composites conformes à la présente invention.

Les mêmes références sur les figures pourront être utilisées pour des éléments de même type. Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

### DESCRIPTION DETAILLEE DE L'INVENTION

La présente invention concerne une structure composite 100 particulièrement adaptée pour la fabrication de composants microélectroniques comprenant une couche mince 10 monocristalline, en particulier en carbure de silicium, en diamant, en silicium, en composés semi-conducteurs II-VI ou III-V (par exemple AIN, GaN,...), ou encore en oxyde de gallium (Ga2O3), disposée sur un substrat support 20 en carbure de silicium poly-cristallin (figure 1).

Dans un plan principal (x,y), la structure composite 100 se présente préférentiellement sous la forme d'une plaquette circulaire (« wafer » selon la terminologie anglo-saxonne) de diamètre de 100mm, 150mm, 200mm, voire plus. Elle pourrait néanmoins se présenter sous toute autre forme permettant son traitement ultérieur pour la fabrication de composants. L'épaisseur de la structure composite 100 s'étend selon l'axe z sur les figures.

La couche mince 10 de la structure composite 100 présente une épaisseur typiquement comprise entre quelques dizaines de nm et quelques centaines de nm, par exemple, entre 50nm et 800nm. Nous verrons par la suite que des étapes d'épitaxie peuvent être mises en œuvre sur ladite couche mince 10, de manière à l'épaissir (homoépitaxie) ou à faire croitre d'autres matériaux (hétéroépitaxie), pour les besoins des composants électroniques à fabriquer.

La couche mince 10 présente une résistivité électrique adaptée à l'application et aux composants visés. Par exemple pour des composants de puissance, sa résistivité est habituellement inférieure à 30mOhm.cm, à 10mOhm.cm, voire à 1mOhm.cm, avec un dopage de type N (dopant azote). Pour des composants RF, sa résistivité pourra être supérieure à 1000hm.cm, voire à 10kOhm.cm, sans dopage spécifique ou avec un ajout par exemple de vanadium.

Le substrat support 20, comme son nom l'indique, correspond au support mécanique de la structure composite 100. Les dimensions latérales dans le plan principal (x,y) du substrat support 20 (son diamètre en particulier) sont les mêmes que celles de la structure composite 100. Il est à noter que la couche mince 10 pourra présenter une dimension latérale légèrement inférieure, du fait du procédé de transfert : en effet, une couronne périphérique du substrat support 20 est habituellement dépourvue de couche mince 10 car la tombée de bord ou le chanfrein du substrat 20 empêchent l'assemblage et le report effectif de ladite couche 10.

Dans la structure composite 100, le substrat support 20 présente une épaisseur typiquement comprise entre plusieurs centaines de microns et environ 50 microns, par exemple entre 800 microns et 50 microns, notamment entre 500 microns et 60 microns, ou encore entre 350 microns et 100 microns.

Lorsqu'une bonne conductivité électrique verticale est requise (applications de puissance), le substrat support 20 présente une résistivité électrique inférieure à 30mOhm.cm, à 15mOhm.cm, voire inférieure à 10mOhm.cm. Lorsque la couche mince 10 est de type N, le type de dopage du substrat support 20 est habituellement choisi identique, soit un dopage typique à l'azote. Pour obtenir la faible résistivité énoncée ci-dessus, la concentration en azote (pouvant être mesurée par spectroscopie de masse des ions secondaires) est généralement supérieure à 5E19 atomes/cm³, préférentiellement supérieure ou égale à 1E20 atomes/cm³, ou encore supérieure ou égale à 1,5E20 atomes/cm³.

Lorsqu'une haute résistivité est visée pour le substrat support (supérieure à 100Ohm.cm, voire à 10kOhm.cm, voire encore supérieure), l'élaboration du substrat support 20 en p-SiC s'opère à partir de précurseurs très purs (par exemple du méthyltrichlorosilane) et/ou avec ajout d'impuretés telles que le vanadium.

Le substrat support 20, en p-SiC de polytype 3C, présente en outre une orientation cristalline préférentielle. L'orientation cristalline préférentielle se caractérise ici avec des proportions particulières de différents coefficients de texture.

Un coefficient de texture peut s'exprimer en pourcentage et quantifie l'orientation préférentielle moyenne des cristallites du substrat support 20 par rapport à la normale à la surface dudit substrat 20. Rappelons que les coefficients de texture peuvent être mesurés grâce à la méthode décrite par G.Harris (« X. Quantitative measurement of preferred orientation in rolled uranium bars", Philosophical Magazine Series 7, 43:336, 113-123, 1952). En pratique, ils sont mesurés à partir des pics de diffraction collectés par un diffractomètre aux rayons X, par la méthode θ-2θ sur une plage d'angle allant de 10° à 135° (échelle 2θ). Sur cette plage, les dix pics de diffraction figurant dans la table (présentée en figure 2) et classés selon des indices de Miller (hkl) croissants, peuvent être pris en compte dans un substrat SiC de polytype 3C.

Un coefficient de texture Cₕₖₗ est calculé à partir de l'intensité du pic Iₕₖₗ, proportionnelle à l'aire sous le pic de l'échantillon, et de l'intensité théorique I_{0 hkl} d'une poudre qui peut être obtenue à partir des pourcentages théoriques édités par l'ICDD (International Centre for Diffraction Data). Un coefficient de texture Cₕₖₗ s'exprime comme suit : Cₕₖₗ = (Iₕₖₗ/ I_{0 hkl})/ (1/N x Σ (Iₕₖₗ / I_{0 hkl})), avec N le nombre de pics pris en compte.

Selon une première variante, l'orientation cristalline préférentielle du substrat support 20 est caractérisée par un coefficient de texture C₄₂₂ inférieur à 30% et un coefficient de texture C₂₂₀ supérieur à 60%.

Selon une deuxième variante, l'orientation cristalline préférentielle du substrat support 20 est caractérisée par un coefficient de texture C₄₂₂ inférieur à 30% et le fait que la somme des coefficients de texture C₁₁₁+C₂₂₂+C₅₁₁ est supérieure à 70%. Préférentiellement, pour l'une et l'autre des variantes énoncées, le coefficient de texture C₄₂₂ est inférieur à 20%, inférieur à 15%, voire inférieur à 10%. Préférentiellement, selon la deuxième variante, la somme des coefficients de texture C₁₁₁+C₂₂₂+C₅₁₁ est supérieure à 80%.

Les figures 3a, 3b et 3c présentent trois exemples de textures de substrats supports 20 pour une structure composite 100 selon l'invention. Les images sont obtenues par microscopie électronique à balayage (MEB) par électrons rétrodiffusés (EBSD), dans le plan transverse (y,z), c'est-à-dire dans une section transversale (en coupe) du substrat support 20. A droite des figures 3a et 3b, un triangle de texture inclut, à titre d'information, certaines facettes repérées par différents symboles blancs ; lesdits symboles sont également reportés sur certaines textures des images MEB, pour illustration. Les pourcentages des principaux coefficients de textures d'intérêt sont indiqués à droite des images MEB sur les trois figures 3a, 3b et 3c.

Les textures préférentielles (selon les deux variantes précitées), associées au fort dopage (lorsqu'une conduction électrique verticale est requise), permettent l'obtention d'un substrat support 20 répondant aux spécifications physiques, mécaniques et électriques attendues dans la structure composite 100, à savoir :
- une excellente planéité (faible courbure),
- une faible résistivité électrique (lorsqu'elle est requise pour l'application et les composants à fabriquer sur la structure composite 100) et,
- une bonne conductibilité thermique (en particulier dans le cas de la 1ère variante énoncée).

Le rayon de courbure du substrat support 20 est supérieur à 25m, avantageusement supérieur ou égal à 50m. A titre d'exemple, un substrat support 20 de 150mm de diamètre présente une courbure (ou « warp ») inférieure ou égale à 100 microns, voire 50 microns, et un substrat support 20 de 200mm de diamètre présente une courbure (ou « warp ») inférieure ou égale à 150 microns, voire 70 microns.

La gamme de rayon de courbure du substrat support 20 rend ce dernier parfaitement compatible avec les spécifications d'une structure composite 100 munie d'une couche mince monocristalline 10, avec le procédé de fabrication d'une telle structure 100 et avec l'élaboration ultérieure de composants microélectroniques sur et/ou dans la couche mince 10. Notons que la courbure de la structure composite 100 reste proche de la courbure du substrat support 20.

Selon un mode particulier de l'invention, la structure composite 100 comprend une couche intermédiaire 30 continue ou discontinue, disposée entre la couche mince 10 et le substrat support 20 et composée d'au moins un matériau métallique ou semi-conducteur (figure 4). Comme cela sera décrit plus loin, en référence à un procédé de fabrication de la structure composite 100, la couche intermédiaire 30 pourra être formée du côté de la couche mince 10, du côté du substrat support 20 ou des deux côtés, préalablement à l'assemblage le long d'une interface de collage 40.

La couche intermédiaire 30 peut être par exemple composée de silicium, de carbure de silicium, de tungstène et/ou de titane. Son épaisseur est typiquement comprise entre quelques nm et quelques centaines de nm, préférentiellement entre 2nm et 50nm.

La présente invention concerne également un procédé de fabrication de la structure composite 100.

Le procédé comprend une première étape a) de fourniture d'un substrat support 20 en carbure de silicium poly-cristallin présentant une orientation cristalline préférentielle selon laquelle :
- un coefficient de texture C₄₂₂ est inférieur à 30%, en particulier inférieur à 20%, à 15%, voire inférieur à 10%, et
- un coefficient de texture C₂₂₀ est supérieur à 60% ou la somme des coefficients de texture C₁₁₁+C₂₂₂+C₅₁₁ est supérieure à 70%, en particulier supérieure à 80%. Préférentiellement, pour adresser les applications d'électronique de puissance, le substrat support 20 présente un dopage à l'azote permettant d'atteindre une résistivité électrique inférieure à 30mOhm.cm, à 15mOhm.cm, voire inférieure à 10mOhm.cm. Le rayon de courbure du substrat support 20 est supérieur à 25m, avantageusement supérieur ou égal à 50m.

L'étape a) met en œuvre une technique de dépôt chimique en phase vapeur (CVD pour « Chemical Vapor Deposition »). Cette technique fait intervenir un mélange gazeux comprenant au moins un gaz précurseur de silicium (tel qu'un silane ou un chlorosilane) et/ou au moins un gaz précurseur de carbone (tel qu'un alcane ou un alcène), et/ou au moins un gaz précurseur de silicium et de carbone (tel que le méthyltrichlorosilane, abrégé MTCS), et, si nécessaire, au moins un gaz dopant comprenant de l'azote (par exemple le NH₃, le N₂H₄, le N₂). Ledit gaz dopant peut aussi être un précurseur de carbone et/ou de silicium (par exemple une amine telle que le H₂NCH₃). Ces gaz peuvent être dilués dans un gaz porteur, qui peut être un gaz réducteur tel que l'hydrogène et/ou un gaz inerte tel que l'argon.

Ce mélange gazeux est admis dans un réacteur se trouvant à haute température où les gaz précurseurs sont décomposés et réagissent sur la surface d'un germe, préférentiellement en graphite isostatique à grain fin et purifié, pour former le polytype 3C-SiC dont les propriétés de résistance mécanique et thermique, le coefficient de dilatation thermique et la pureté sont parfaitement compatibles avec les spécifications de la structure composite 100. Le polytype 3C-SiC, par ailleurs, peut être dopé avec de l'azote jusqu'à des niveaux très élevés, typiquement 10²⁰ atomes/cm³, et présenter ainsi une résistivité inférieure à 30mOhm.cm, sans dégradation de la qualité du substrat qui serait préjudiciable à la qualité de la structure composite et ultérieurement aux performances des composants microélectroniques. Enfin, c'est un matériau capable de résister aux procédés à hautes températures que devra subir le substrat support 20 pendant la fabrication de la structure composite 100 et des composants. La température du réacteur lors du dépôt par CVD du SiC doit se situer entre environ 1000°C et environ 1600°C, préférentiellement entre environ 1100°C et environ 1400°C. Dans cette plage de température, les vitesses de dépôt peuvent évoluer dans des plages assez larges, du micron/h à plus de 100 microns/h. Avantageusement, la pression totale dans le réacteur ne dépasse pas 350 mbar, voire 300 mbar.

En modifiant les paramètres du procédé CVD tels que la température, la pression partielle du précurseur et potentiellement le pourcentage de gaz dopant, il est possible de faire évoluer l'orientation cristalline/la texture de la couche p-SiC déposée.

A l'issue du dépôt, les germes en graphite revêtus par une épaisse couche de dépôt de SiC sont usinés, puis oxydés à l'air typiquement à 900°C pour éliminer tout résidu de graphite. Notons que le retrait des germes de graphite pourrait également être opéré par des techniques d'usinage uniquement mécanique ou encore essentiellement par brulage/oxydation.

Un disque de p-SiC brut est récupéré pour chaque face d'un germe. Le disque p-SiC brut présente une courbure du fait de la relaxation des contraintes de la couche déposée. Cette courbure peut être mesurée grâce à un capteur confocal en lumière blanche qui scanne une surface du disque en p-SiC.

Le disque p-SiC brut subit ensuite des amincissements par rectification grossière puis fine, et des préparations de surface par polissage pour aboutir au substrat support 20 en p-SiC présentant les caractéristiques clés énoncées précédemment, lors de la description de la structure composite 100. L'étape de rectification vise notamment à éliminer une épaisseur suffisante du côté de la face du disque qui était en contact avec le graphite. On retire ainsi la zone de croissance initiale des cristaux, génératrice de fortes contraintes.

Il est important que la courbure du disque en p-SiC brut demeure dans une gamme raisonnable pour permettre l'élaboration d'un substrat support 20 à faible courbure, à partir d'un disque brut d'épaisseur économiquement viable. Par exemple, la courbure (« warp ») d'un disque en p-SiC brut de diamètre 150mm et d'épaisseur inférieure à 900 microns est visée inférieure ou égale à 250 microns. Il est ainsi possible après rectification et polissage d'obtenir un substrat support 20 d'épaisseur typiquement inférieure à 500 microns et de courbure (« warp ») inférieure à 100 microns, voire inférieure à 50 microns, voire encore inférieure à 30 microns.

La figure 6 présente un tableau avec différentes conditions de dépôt du p-SiC (température, gaz précurseur, pression, fraction molaire de gaz dopant) et les propriétés mécaniques, électriques et thermiques obtenues. Les échantillons 2, 3 et 4 sont représentatifs des substrats supports 20 pour une structure composite 100 conforme à la présente invention ; leurs textures sont illustrées respectivement sur les figures 3c, 3a et 3b.

Les échantillons 1 et 5 ne permettent pas d'atteindre les spécifications requises (résistivité, courbure) pour la fabrication d'une structure composite 100 de haute qualité et ne rentrent donc pas dans la présente invention. Les textures de ces échantillons ne sont pas favorables à une faible courbure et la taille des grains au niveau de la surface 20a, plus importante et hétérogène que pour les échantillons 2, 3 et 4, complexifie la préparation de surface et l'obtention de l'état de surface requis pour un assemblage direct.

La face 20a du substrat support 20 (figure 5a) destinée à recevoir la couche mince 10 présente préférentiellement une rugosité inférieure ou égale à 1nm RMS (mesurée par microscopie à force atomique sur des scans de 20 microns x 20 microns), encore préférentiellement inférieure ou égale à 0,5nm RMS. La face du substrat support 20 destinée à former la face arrière de la structure composite 100 peut présenter une rugosité de surface plus importante, par exemple de l'ordre de 10nm RMS.

L'étape a) du procédé peut éventuellement inclure un traitement thermique appliqué au substrat support 20, à une température supérieure ou égale à 1500°C, typiquement entre 1500°C et 2000°C, de manière à stabiliser sa structure poly-cristalline. En effet, ces gammes de températures sont susceptibles d'être appliquées plus tard dans le procédé pour la fabrication de la structure composite 100.

Le procédé de fabrication selon l'invention comprend ensuite une étape b) de fourniture d'un substrat donneur 1 en un matériau monocristallin dont sera issue la couche mince 10 (figure 5a). Comme évoqué précédemment en référence à la structure composite 100, le matériau monocristallin peut être le carbure de silicium de polytype 4H, 6H ou 3C, le diamant, le silicium, les composés semi-conducteurs II-IV ou III-V (notamment GaN), etc. Le substrat donneur 1 se présente préférentiellement sous la forme d'une plaquette de diamètre 100mm, 150mm, 200mm voire plus (identique à ou très proche de celui du substrat support 20) et d'épaisseur comprise typiquement entre 300 microns et 800 microns. Il présente une face avant 1a et une face arrière 1b. La rugosité de surface de la face avant 1a est avantageusement choisie inférieure à 1nm RMS, voire inférieure à 0,5nm RMS, mesurée par microscopie à force atomique (AFM) sur un scan de 20 microns x 20 microns. Le type de dopage et la résistivité du substrat donneur 1 sont définis en fonction des besoins des composants qui seront élaborés sur et/ou dans la couche mince 10 de la structure composite 100.

Enfin, le procédé comprend une étape c) de transfert d'une couche mince 10 issue du substrat donneur 1 sur le substrat support 20. Il existe différentes options, connues de l'état de la technique pour effectuer un transfert de couche (amincissement mécanique, chimique ou mécano-chimique, séparation au niveau d'une couche poreuse présente dans le substrat donneur 1...), qui ne seront pas décrites ici de manière exhaustive.

Selon un mode préféré, l'étape c) du procédé implique une implantation d'espèces légères et un assemblage par collage direct, selon le principe du procédé Smart Cut^{™}.

Une première phase c1) correspond à l'introduction d'espèces légères dans le substrat donneur 1 pour former un plan fragile enterré 11 délimitant, avec une face avant 1a du substrat donneur 1, la couche mince 10 à transférer (figure 5b). Notons que même si la couche mince 10 à transférer est illustrée comme une couche continue, elle pourrait également être constituée de pavés discontinus, par exemple préparés à la surface du substrat donneur 1.

Les espèces légères sont préférentiellement de l'hydrogène, de l'hélium ou une co-implantation de ces deux espèces, et sont implantées à une profondeur déterminée dans le substrat donneur 1, cohérente avec l'épaisseur de la couche mince 10 visée. Ces espèces légères vont former, autour de la profondeur déterminée, des microcavités distribuées dans une fine couche parallèle à la surface libre 1a du substrat donneur 1, soit parallèle au plan (x,y) sur les figures. On appelle cette fine couche le plan fragile enterré 11, par souci de simplification.

L'énergie d'implantation des espèces légères est choisie de manière à atteindre la profondeur déterminée. Par exemple, des ions hydrogène seront implantés à une énergie comprise entre 10 keV et 250 keV, et à une dose comprise entre 5^{E}16/cm² et 1^{E}17/cm², pour délimiter une couche mince 10 présentant une épaisseur de l'ordre de 100nm à 1500nm. Notons qu'une couche de protection pourra être déposée sur la face avant 1a du substrat donneur 1, préalablement à l'étape d'implantation ionique. Cette couche de protection peut être composée par un matériau tel que l'oxyde de silicium ou le nitrure de silicium par exemple. Elle est retirée préalablement à la phase suivante.

L'étape c) de transfert comprend ensuite une deuxième phase c2) d'assemblage du substrat donneur 1, du côté de sa face avant 1a, sur le substrat support 20, du côté de sa première face 20a, par collage par adhésion moléculaire, le long d'une interface de collage 40 (figure 5c).

Optionnellement, une couche intermédiaire 30 peut être formée sur la face avant 1a du substrat donneur 1, avant ou après l'introduction des espèces légères de la phase c1), et en tout état de cause, avant la phase d'assemblage. Cette couche intermédiaire 30 peut être en un matériau semi-conducteur, par exemple silicium ou carbure de silicium, ou en un matériau métallique tel que le tungstène, le titane, etc. L'épaisseur de la couche intermédiaire 30 est avantageusement limitée, typiquement entre quelques nanomètres et quelques dizaines de nanomètres.

Dans le cas où la couche intermédiaire 30 est formée avant la première phase c1), l'énergie d'implantation (et potentiellement la dose) des espèces légères sera ajustée à la traversée de cette couche supplémentaire. Dans le cas où la couche intermédiaire 30 est formée après la phase c1), on prendra soin de former cette couche en appliquant un budget thermique inférieur au budget thermique de bullage, ledit budget thermique de bullage correspondant à l'apparition de cloques à la surface du substrat donneur 1 du fait d'une croissance et d'une mise sous pression trop importante des microcavités dans le plan fragile enterré 11.

De manière optionnelle, une couche intermédiaire 30 peut également être déposée sur la face à assembler du substrat support 20, préalablement à la phase d'assemblage ; elle peut être choisie de même nature ou de nature différente de la couche intermédiaire évoquée pour le substrat donneur 1. Une couche intermédiaire 30 peut éventuellement être déposée sur l'un et l'autre des deux substrats 1,10 à assembler.

L'objectif de la (ou des) couche(s) intermédiaire(s) est essentiellement de favoriser l'énergie de collage (notamment dans la gamme de températures inférieures à 1100°C), du fait de la formation de liaisons covalentes à plus basses températures que dans le cas de deux surfaces SiC assemblées directement ; un autre avantage de cette(ces) couche(s) intermédiaire(s) peut être d'améliorer la conduction électrique verticale de l'interface de collage 40.

La (ou les) couche(s) intermédiaire(s) 30 est(sont) destinée(s) à être enterrée(s) dans l'ensemble collé 50 après assemblage (figures 5c', 5c"), et à terme, dans la structure composite 100. Même si la couche intermédiaire 30 est continue lors de sa formation sur l'un et/ou l'autre des substrats 1,20, elle peut, au cours des traitements thermiques ultérieurs se segmenter et présenter un caractère discontinu. C'est essentiellement le cas lorsque l'épaisseur initiale de ladite couche est très faible, typiquement inférieure à 10nm.

Revenant à la description de la phase c2) d'assemblage, et comme cela est bien connu en soi, le collage direct par adhésion moléculaire ne nécessite pas une matière adhésive, car des liaisons s'établissent à l'échelle atomique entre les surfaces assemblées. Plusieurs types de collage par adhésion moléculaire existent, qui diffèrent notamment par leurs conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

La phase c2) d'assemblage peut comprendre, préalablement à la mise en contact des faces 1a,20a à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 40 (faible défectivité, forte énergie d'adhésion).

Enfin, une troisième phase c3) comprend la séparation le long du plan fragile enterré 11, qui mène au report de la couche mince 10 sur le substrat support 20 (figure 5d). La séparation le long du plan fragile enterré 11 s'opère habituellement par l'application d'un traitement thermique à une température comprise entre 800°C et 1200°C. Un tel traitement thermique induit le développement des cavités et microfissures dans le plan fragile enterré 11, et leur mise sous pression par les espèces légères présentes sous forme gazeuse, jusqu'à la propagation d'une fracture le long dudit plan fragile 11. Alternativement ou conjointement, une sollicitation mécanique peut être appliquée à l'ensemble collé et en particulier au niveau du plan fragile enterré 11, de manière à propager ou aider à propager mécaniquement la fracture menant à la séparation. A l'issue de cette séparation, on obtient d'une part la structure composite 100 comprenant le substrat support 20 et la couche mince 10 transférée, et d'autre part, le reste 1' du substrat donneur. Le niveau et le type de dopage de la couche mince 10 sont définis par le choix des propriétés du substrat donneur 1 ou peuvent être ajustés ultérieurement via les techniques connues de dopage de couches semi-conductrices.

La surface libre 10a de la couche mince 10 est habituellement rugueuse après séparation : par exemple, elle présente une rugosité comprise entre 5nm et 100nm RMS. Des phases de nettoyage et/ou de lissage peuvent être appliquées pour restaurer un bon état de surface (typiquement, une rugosité inférieure à quelques angströms RMS). En particulier, ces phases peuvent comprendre un traitement de lissage mécano-chimique de la surface libre de la couche mince 20. Un enlèvement compris entre 50nm et 300nm permet de restaurer efficacement l'état de surface de ladite couche 10. Elles peuvent également comprendre au moins un traitement thermique à une température comprise entre 1200°C et 1800°C. Un tel traitement thermique est appliqué pour évacuer les espèces légères résiduelles de la couche mince 10 et pour favoriser le réarrangement du réseau cristallin de la couche mince 10. Il permet en outre de renforcer l'interface de collage 40. Le traitement thermique peut également comprendre ou correspondre à une épitaxie sur la couche mince 10, afin d'augmenter l'épaisseur de cette dernière (par exemple, homoépitaxie de c-SiC sur une couche mince 10 en c-SiC, hétéroépitaxie de GaN sur une couche mince 10 en c-SiC, ou autre).

Enfin, notons que l'étape c) de transfert peut comprendre une étape de reconditionnement du reste 1' du substrat donneur en vue d'une réutilisation en tant que substrat donneur 1 pour une nouvelle structure composite 100. Des traitements mécaniques et/ou chimiques, similaires à ceux appliqués à la structure composite 100, peuvent être mis en œuvre au niveau de la face avant 1'a du substrat restant 1'.

La structure composite 100 obtenue est extrêmement robuste aux traitements thermiques à très hautes températures susceptibles d'être appliqués pour améliorer la qualité de la couche mince 10 ou pour fabriquer des composants sur et/ou dans ladite couche 10. Le substrat support 20 dans la structure composite 100 est stable et ne voit pas sa courbure augmenter de façon rédhibitoire pendant les traitements thermiques à hautes températures appliqués à la structure composite 100 pour sa fabrication et ultérieurement.

La structure composite 100 selon l'invention est particulièrement adaptée pour l'élaboration d'un (ou plusieurs) composant(s) microélectronique(s) à haute tension, tels que par exemple des diodes Schottky, des transistors MOSFET, etc. Elle répond plus généralement aux applications microélectroniques de puissance, en autorisant une excellente conduction électrique verticale, une bonne conductibilité thermique et en procurant une couche mince en c-SiC de haute qualité.

La structure composite 100 peut également répondre aux applications radiofréquences, avec un substrat support 20 résistif dont les caractéristiques physiques et potentiellement thermiques sont parfaitement adaptées à la fabrication de composants électroniques RF.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Structure composite (100) pour la fabrication de composants microélectroniques comprenant une couche mince (10) monocristalline, disposée sur un substrat support (20) en carbure de silicium poly-cristallin, la structure composite (100) étant **caractérisée en ce que** ledit substrat support (20) présente une orientation cristalline préférentielle selon laquelle :
- un coefficient de texture C₄₂₂ est inférieur à 30%, en particulier inférieur à 20%, et
- un coefficient de texture C₂₂₀ est supérieur à 60% ou la somme des coefficients de texture C₁₁₁+C₂₂₂+C₅₁₁ est supérieure à 70%, en particulier supérieure à 80%.

2. Structure composite (100) selon la revendication précédente, dans laquelle le substrat support (20) présente un dopage à l'azote et une résistivité inférieure à 30mOhm.cm.

3. Structure composite (100) selon l'une des revendications précédentes, dans laquelle la couche mince (10) est composée de carbure de silicium.

4. Structure composite (100) selon l'une des revendications 1 et 2, dans laquelle la couche mince (10) est composée de diamant.

5. Structure composite (100) selon l'une des revendications précédentes, comprenant une couche intermédiaire (30) continue ou discontinue, disposée entre la couche mince (10) et le substrat support (20) et composée d'au moins un matériau métallique ou semi-conducteur.

6. Structure composite (100) selon la revendication précédente, dans laquelle la couche intermédiaire (30) est composée de silicium, de carbure de silicium, de tungstène, et/ou de titane.

7. Structure composite (100) selon l'une des revendications précédentes, dans laquelle le coefficient de texture C₄₂₂ est inférieur à 15%, voire inférieur à 10%.

8. Structure composite (100) selon l'une des revendications précédentes, dans laquelle le substrat support (20) présente une épaisseur comprise entre 50 microns et 800 microns, préférentiellement entre 60 microns et 500 microns.

9. Structure composite (100) selon l'une des revendications précédentes, comprenant un composant électronique sur et/ou dans la couche mince (10) et comprenant optionnellement un contact électrique au niveau de la face arrière du substrat support (20).

10. Procédé de fabrication d'une structure composite (100) comportant une couche mince (10) monocristalline disposée sur un substrat support (20) en carbure de silicium poly-cristallin, le procédé de fabrication comprenant les étapes suivantes :
a) la fourniture d'un substrat support (20) en carbure de silicium poly-cristallin présentant une orientation cristalline préférentielle selon laquelle :
- un coefficient de texture C₄₂₂ est inférieur à 30%, en particulier inférieur à 20%, et
- un coefficient de texture C₂₂₀ est supérieur à 60% ou la somme des coefficients de texture C₁₁₁+C₂₂₂+C₅₁₁ est supérieure à 70%, en particulier supérieure à 80%,
b) la fourniture d'un substrat donneur (1) en un matériau monocristallin,
c) le transfert d'une couche mince (10) issue du substrat donneur (1) sur le substrat support (20).

11. Procédé de fabrication selon la revendication précédente, dans lequel l'étape c) de transfert comprend :
c1) la formation d'un plan fragile enterré (11) dans le substrat donneur (1), délimitant la couche mince (10) entre ledit plan fragile enterré (11) et une face avant (1a) du substrat donneur (1),
c2) l'assemblage par collage par adhésion moléculaire du substrat donneur (1) sur le substrat support (20), directement ou via une couche intermédiaire (30),
c3) la séparation le long du plan fragile enterré (11) pour donner lieu au transfert de la couche mince (10) sur le substrat support (20).

12. Procédé de fabrication selon la revendication précédente, dans lequel l'étape c2) comprend, avant l'assemblage des deux substrats (1,20) :
- la formation d'une couche intermédiaire (30) sur le substrat donneur (1), avant ou après l'étape c1), et/ou
- la formation d'une couche intermédiaire (30) sur le substrat support (20),
la couche intermédiaire (30) étant formée en au moins un matériau métallique ou semi-conducteur, choisi parmi le silicium, le carbure de silicium, le tungstène et le titane.

13. Procédé de fabrication selon l'une des deux revendications précédentes, dans lequel le matériau monocristallin composant le substrat donneur (1) est le carbure de silicium.

14. Procédé de fabrication selon l'une des revendications 10 à 13, comprenant en outre l'élaboration de composants électroniques sur et/ou dans la couche mince (10) de la structure composite (100).

15. Procédé de fabrication selon la revendication précédente, dans lequel l'élaboration de composants électroniques comprend notamment une étape d'homoépitaxie ou d'hétéroépitaxie sur la couche mince (10).

## Patentansprüche

1. Verbundstruktur (100) zur Herstellung mikroelektronischer Bauelemente, umfassend eine einkristalline Dünnschicht (10), die auf einem Trägersubstrat (20) aus polykristallinem Siliciumcarbid angeordnet ist, wobei die Verbundstruktur (100) **dadurch gekennzeichnet ist, dass** das Trägersubstrat (20) eine bevorzugte kristallographische Orientierung aufweist, gemäß der:
- ein Texturkoeffizient C₄₂₂ kleiner als 30 %, insbesondere kleiner als 20 %, liegt, und
- ein Texturkoeffizient C₂₂₀ größer als 60 % ist oder die Summe der Texturkoeffizienten C₁₁₁+C₂₂₂+C₅₁₁ größer als 70 % , insbesondere größer als 80 %, ist.

2. Verbundstruktur (100) nach dem vorstehenden Anspruch, wobei das Trägersubstrat (20) eine Stickstoffdotierung und einen spezifischen elektrischen Widerstand von weniger als 30 mOhm.cm aufweist.

3. Verbundstruktur (100) nach einem der vorstehenden Ansprüche, wobei die Dünnschicht (10) aus Siliciumcarbid besteht.

4. Verbundstruktur (100) nach einem der Ansprüche 1 und 2, wobei die Dünnschicht (10) aus Diamant besteht.

5. Verbundstruktur (100) nach einem der vorstehenden Ansprüche, umfassend eine kontinuierliche oder diskontinuierliche Zwischenschicht (30), die zwischen der Dünnschicht (10) und dem Trägersubstrat (20) angeordnet ist und aus mindestens einem metallischen oder halbleitenden Material besteht.

6. Verbundstruktur (100) nach dem vorstehenden Anspruch, wobei die Zwischenschicht (30) aus Silicium, Siliciumcarbid, Wolfram und/oder Titan besteht.

7. Verbundstruktur (100) nach einem der vorstehenden Ansprüche, wobei der Texturkoeffizient C₄₂₂ kleiner als 15 %, vorzugsweise kleiner als 10 %, ist.

8. Verbundstruktur (100) nach einem der vorstehenden Ansprüche, wobei das Trägersubstrat (20) eine Dicke zwischen 50 Mikrometern und 800 Mikrometern, vorzugsweise zwischen 60 Mikrometern und 500 Mikrometern, aufweist.

9. Verbundstruktur (100) nach einem der vorstehenden Ansprüche, umfassend ein elektronisches Bauelement auf und/oder in der Dünnschicht (10) und optional umfassend einen elektrischen Kontakt an der Rückseite des Trägersubstrats (20).

10. Verfahren zur Herstellung einer Verbundstruktur (100) mit einer einkristallinen Dünnschicht (10), die auf einem Trägersubstrat (20) aus polykristallinem Siliciumcarbid angeordnet ist, wobei das Herstellungsverfahren die folgenden Schritte umfasst:
a) die Bereitstellung eines Trägersubstrats (20) aus polykristallinem Siliciumcarbid, das eine bevorzugte kristallographische Orientierung aufweist, gemäß der:
- ein Texturkoeffizient C₄₂₂ kleiner als 30 %, insbesondere kleiner als 20 %, ist, und
- ein Texturkoeffizient C₂₂₀ größer als 60 % ist oder die Summe der Texturkoeffizienten C₁₁₁+C₂₂₂+C₅₁₁ größer als 70 %, insbesondere größer als 80 %, ist,
b) die Bereitstellung eines Donorsubstrats (1) aus einem einkristallinen Material,
c) die Übertragung einer aus dem Donorsubstrat (1) stammenden Dünnschicht (10) auf das Trägersubstrat (20).

11. Verfahren zur Herstellung nach dem vorstehenden Anspruch, wobei der Übertragungsschritt c) umfasst:
c1) die Bildung einer vergrabenen Schwächungsebene (11) in dem Donorsubstrat (1), die die Dünnschicht (10) zwischen der genannten vergrabenen Schwächungsebene (11) und einer Vorderseite (1a) des Donorsubstrats (1) begrenzt,
c2) die Verbindung des Donorsubstrats (1) mit dem Trägersubstrat (20) durch Molekularhaftbonden, direkt oder über eine Zwischenschicht (30),
c3) die Trennung entlang der vergrabenen Schwächungsebene (11), um die Übertragung der Dünnschicht (10) auf das Trägersubstrat (20) zu bewirken.

12. Verfahren zur Herstellung nach dem vorstehenden Anspruch, wobei der Schritt c2) vor dem Verbinden der beiden Substrate (1, 20) Folgendes umfasst:
- die Bildung einer Zwischenschicht (30) auf dem Donorsubstrat (1), vor oder nach dem Schritt c1), und/oder
- die Bildung einer Zwischenschicht (30) auf dem Trägersubstrat (20),
wobei die Zwischenschicht (30) aus mindestens einem metallischen oder halbleitenden Material gebildet ist, ausgewählt aus Silicium, Siliciumcarbid, Wolfram und Titan.

13. Verfahren zur Herstellung nach einem der beiden vorstehenden Ansprüche, wobei das das Donorsubstrat (1) bildende einkristalline Material Siliciumcarbid ist.

14. Verfahren zur Herstellung nach einem der Ansprüche 10 bis 13, umfassend die Herstellung elektronischer Bauelemente auf und/oder in der Dünnschicht (10) der Verbundstruktur (100).

15. Verfahren zur Herstellung nach dem vorstehenden Anspruch, wobei die Herstellung elektronischer Bauelemente insbesondere einen Schritt der Homoepitaxie oder der Heteroepitaxie auf der Dünnschicht (10) umfasst.

## Claims

1. Composite structure (100) for manufacturing microelectronic components, comprising a monocrystalline thin layer (10) disposed over a polycrystalline silicon carbide support substrate (20), the composite structure (100) being **characterised in that** said support substrate (20) has a preferential crystallographic orientation according to which:
- a texture coefficient C₄₂₂ is lower than 30%, in particular lower than 20%, and
- a texture coefficient C₂₂₀ is greater than 60%, or the sum of the texture coefficients C₁₁₁+C₂₂₂+C₅₁₁ is greater than 70%, in particular greater than 80%.

2. Composite structure (100) according to the preceding claim, wherein the support substrate (20) has nitrogen doping and a resistivity lower than 30mOhm.cm.

3. Composite structure (100) according to one of the preceding claims, wherein the thin layer (10) is composed of silicon carbide.

4. Composite structure (100) according to one of claims 1 and 2, wherein the thin layer (10) is composed of diamond.

5. Composite structure (100) according to one of the preceding claims, comprising a continuous or discontinuous intermediate layer (30), disposed between the thin layer (10) and the support substrate (20), and composed of at least one metallic or semiconductor material.

6. Composite structure (100) according to the preceding claim, wherein the intermediate layer (30) is composed of silicon, silicon carbide, tungsten and/or titanium.

7. Composite structure (100) according to one of the preceding claims, wherein texture coefficient C₄₂₂ is lower than 15%, or even lower than 10%.

8. Composite structure (100) according to one of the preceding claims, wherein the support substrate (20) has a thickness comprised between 50 microns and 800 microns, preferably between 60 microns and 500 microns.

9. Composite structure (100) according to one of the preceding claims, comprising an electronic component on and/or in the thin layer (10), and optionally comprising an electrical contact on the rear face of the support substrate (20).

10. Method for manufacturing a composite structure (100) comprising a monocrystalline thin layer (10) disposed over a polycrystalline silicon carbide support substrate (20), the manufacturing method comprising the following steps:
a) providing a polycrystalline silicon carbide support substrate (20) having a preferential crystallographic orientation according to which:
- a texture coefficient C₄₂₂ is lower than 30%, particularly lower than 20%, and
- a texture coefficient C₂₂₀ is greater than 60%, or the sum of the texture coefficients C₁₁₁+C₂₂₂+C₅₁₁ is greater than 70%, in particular greater than 80%,
b) providing a donor substrate (1) made of a monocrystalline material,
c) transferring a thin layer (10) originating from the donor substrate (1) onto the support substrate (20).

11. Manufacturing method according to the preceding claim, wherein transfer step c) comprises:
c1) forming a buried weakened plane (11) in the donor substrate (1), delimiting the thin layer (10) between said buried weakened plane (11) and a front face (1a) of the donor substrate (1),
c2) bonding the donor substrate (1) to the support substrate (20) by molecular adhesion bonding, directly or via an intermediate layer (30),
c3) separating along the buried weakened plane (11) so as to transfer the thin layer (10) onto the support substrate (20).

12. Manufacturing method according to the preceding claim, wherein step c2) comprises, prior to bonding the two substrates (1, 20):
- forming an intermediate layer (30) on the donor substrate (1), before or after step c1), and/or
- forming an intermediate layer (30) on the support substrate (20),
the intermediate layer (30) being formed of at least one metallic or semiconductor material selected from silicon, silicon carbide, tungsten and titanium.

13. Manufacturing method according to one of the two preceding claims, wherein the monocrystalline material composing the donor substrate (1) is silicon carbide.

14. Manufacturing method according to one of claims 10 to 13, further comprising forming electronic components on and/or in the thin layer (10) of the composite structure (100).

15. Manufacturing method according to the preceding claim, wherein the forming of electronic components notably comprises a step of homoepitaxy or heteroepitaxy on the thin layer (10).
